# EUROPÄISCHE PATENTSCHRIFT

(11) **EP 3 631 923 B1**
(45) Veröffentlichungstag und Bekanntmachung des Hinweises auf die Patenterteilung: **18.01.2023**
(21) Anmeldenummer: 18726965.9
(22) Anmeldetag: 22.05.2018
(51) Int. Cl.: H02B 1/28

(54) **GESCHWEISSTE DRUCKENTLASTUNGSVORRICHTUNG**
WELDED PRESSURE RELEASE DEVICE
DISPOSITIF DE DÉCHARGE DE PRESSION SOUDÉ

(30) Priorität: 01.06.2017 DE 102017112149; 04.10.2017 DE 102017122957
(43) Veröffentlichungstag der Anmeldung: 08.04.2020
(73) Patentinhaber: R. STAHL Schaltgeräte GmbH, 74638 Waldenburg (DE)
(72) Erfinder: ARNHOLD, Thorsten, 74629 Pfedelbach (DE); HERMANOWSKI, Clife, 74743 Seckach (DE)
(74) Vertreter: Rüger Abel Patentanwälte PartGmbB
(86) Internationale Anmeldenummer: PCT/EP2018/063336
(87) Internationale Veröffentlichungsnummer: WO 2018/219711

(56) Entgegenhaltungen:
- DE-A1-102013 109 259
- DE-U1- 9 117 129
- DE-U1-202008 001 972

## Beschreibung

Gegenstand der Erfindung ist eine Druckentlastungsvorrichtung für ein explosionsgeschütztes Gehäuse nach der Bauart "druckfeste Kapselung" (ex-d) sowie ein Verfahren zu dessen Herstellung.

Explosionsgeschützte Gehäuse der genannten Bauart dienen der Aufnahme von Komponenten, beispielsweise elektrischen und/oder elektronischen Bauteilen, die Zündquellen für explosionsfähige Gase darstellen können. Sind solche Gase in das Gehäuse gelangt, gestatten Druckentlastungsvorrichtungen den Abbau von durch die Verpuffung im Gehäuse entstandenem Überdruck, wobei sie das Durchschlagen von Flammen oder glühenden Partikeln verhindern, um eine Zündung einer vorhandenen explosionsgefährdeten Atmosphäre außerhalb des Gehäuses auszuschließen.

Eine typische, diesem Zweck dienende Druckentlastungsvorrichtung ist der US 4,180,177 A zu entnehmen. Der poröse Druckentlastungskörper ist gasdurchlässig und wird, zwischen Ringflanschen geklemmt, in einer Druckentlastungsöffnung gehalten.

Ebenso beschreibt die DE 10 2010 016 782 A1 die Befestigung eines Druckentlastungskörpers durch Einspannen seiner ringförmigen Randzone zwischen entsprechenden Lagern und Flanschen. Außerdem beschreibt diese Druckschrift den Porenverschluss des Druckentlastungskörpers an seiner Umfangfläche mittels plastischen Materials, das die Poren der Umfangsfläche infiltriert und schließt. Zur Ummantelung können Materialien wie Kunststoff, Metall, ein Elastomer oder Ähnliches dienen.

Außerdem ist aus der DE 1 041 449 A eine explosionssicheres Gehäuse aus Metall bekannt, das eine mittels einer Filterplatte verschlossene Rechtecköffnung aufweist. Die Filterplatte ist mittels eines gleichfalls rechteckigen Rahmens gegen die Außenseite des Gehäuses gespannt, um die Rechtecköffnung abzudichten. Zwischen der Filterplatte und dem Behälter ist eine Metallgewebedichtung angeordnet.

Schließlich ist aus der DE 1 839 917 U eine Flammensperre mit einem Sintermetallkörper bekannt, der etwa einseitig geschlossen hohlzylindrisch ausgebildet ist. Der Sintermetallkörper ist mit einem massiven Ansatzstück aus gleichem Material versintert, das seinerseits mit dem Gehäuse verschraubt ist.

Die DE 10 2014 116 149 A1 empfiehlt als Druckentlastungskörper für Druckentlastungsvorrichtungen einen aus einer größeren Anzahl von Drahtgewebelagen gesinterten Körper, bei dem die Drahtgewebelagen hinsichtlich Maschengröße und Anordnung so aufeinander abgestimmt sind, dass ein starrer gasdurchlässiger, jedoch flammendurchschlagsicherer Körper gebildet ist. Dieser Druckentlastungskörper ist wiederum in einer Druckentlastungsöffnung eines Gehäuses angeordnet.

Aus der DE 10 2013 109 259 A1 ist ein explosionsgeschütztes Gehäuse mit einer Druckentlastungsvorrichtung bekannt, die durch einen porösen gasdurchlässigen Körper gebildet ist. Das Gehäuse kann im Gussverfahren hergestellt sein. Der poröse Körper kann dabei in die Gussform eingelegt werden, sodass er sich mit dem Gusswerkstoff verbindet. Um ein Eindringen des Gusswerkstoffs in den porösen Körper zu hemmen, kann die Porosität desselben im Randberiech geringer sein als im Übrigen. Auch wird gefasst ein gewisses Anschmelzen des porösen Körpers an seiner Umfangsfläche in Kauf zu nehmen, um eine stoffschlüssige Verbindung zu dem im Gießprozess flüssigen Gehäusematerial herzustellen.

Der DE 20 2008 001972 U1 beschreibt ein explosionsgeschütztes Gehäuse mit einer Öffnung, die mittels Druckentlastungsvorrichtung geschlossen ist. Der Druckentlastungsvorrichtung wird von einem Kunststoffring gehalten, der an seinem oberen Rand mit dem Gehäuse verschweißt ist. Auf diese Weise ist der Druckentlastungsvorrichtung zwischen einer Auflagefläche des Gehäuses und einer Muffe eingeklemmt.

Der DE 91 17 129 U1 beschreibt einen Druckentlastungskörper für einen Gehäuse, der aus mehreren Lagen Streckmetallgitters gebildet ist. Der Druckentlastungskörper ist in einem Blechrahmen gefasst. Ein Rand eines oberen Blechs des Rahmens ist mit dem Gehäusewandabschnitt verschweißt.

Während der Schutz gegen Flammendurchschlag seitens des Druckentlastungskörpers durch dessen sorgfältigen Aufbau und durch entsprechende Fertigungskontrolle sichergestellt werden kann, ist die flammendurchschlagsichere Befestigung des Druckentlastungskörpers in oder an einer Druckentlastungsöffnung eines Gehäuses ein Problem, das besonderer Aufmerksamkeit bedarf. Auch nach längerer Benutzung muss Sicherheit gegen Flammendurchschlag bestehen, Fehlfunktionen müssen sicher ausgeschlossen werden.

Davon ausgehend ist es eine Aufgabe der Erfindung, ein serientaugliches Konzept zur Befestigung von Druckentlastungskörpern an Druckausgleichsöffnungen von Gehäusen oder Gehäuseteilen anzugeben.

Diese Aufgabe wird mit dem Gehäuse nach Anspruch 1 wie auch mit dem Verfahren nach Anspruch 10 gelöst:

Bei dem erfindungsgemäßen Gehäuse ist der Druckentlastungskörper an einer Druckausgleichsöffnung angeordnet und dort mit einem Gehäuseteil verschweißt oder anderweitig stoffschlüssig verbunden. Dieses Konzept ist grundsätzlich bei allen schweißgeeigneten Druckentlastungskörpern und Gehäuseteilen einsetzbar. Insbesondere eignet sich dieses Konzept für Druckentlastungskörper und Gehäuseteile aus Stahl. Der Druckentlastungskörper wird vorzugsweise an der Innenseite des Gehäuses angeordnet und durch ein oder mehrere Schweißnähte befestigt.

Vorzugsweise besteht der Druckentlastungskörper aus mehreren Lagen aufeinanderliegend angeordneter Drahtnetze. Vorzugsweise sind diese untereinander durch Sinterung verbunden. Ein derartiger Druckentlastungskörper ist starr und im Rohzustand sowohl an seinen beiden Flachseiten wie auch an seiner Umfangsfläche porenoffen. Die Drahtnetze bestehen vorzugsweise aus einem korrosionsträgen, z.B. rostfreien Stahl, z.B. Edelstahl.

Bei einer bevorzugen Ausführungsform ist diese Umfangsfläche als glatte Schnittfläche ausgebildet. Erfindungsgemäß ist die Umfangsfläche mit einer Verschmelzungsschicht versehen. Die Verschmelzungsschicht kann durch eine Anschmelzung der Umfangsfläche und/oder durch Aufbringen eines Zusatzwerkstoffs, beispielsweise in einem Schweißverfahren ausgebildet sein. Die Verschmelzungsschicht kann durch eine Einbrandzone gebildet sein, die durch flächenhafte Einwirkung von Wärme erzeugt ist. Die Wärmeeinwirkung erfolgt vorzugsweise lokal und kontrolliert über die Umfangsfläche fortschreitend z.B. mittels bewegtem Lichtbogen, bewegtem Laserstrahl oder eine andere bewegte lokal wirksame Energiequelle. Das bevorzugte Verfahren ist dabei ein Laser-Pulver-Schweißverfahren, bei dem mittels eines Laserstrahls Metallpulver unter Schutzgas aufgeschmolzen wird. Als Zusatzwerkstoff eignet sich insbesondere zum Verbindungs- und Auftragschweißen geeignetes Metallpulver, wie Pulver der Stahlsorte 1.4430.

Die Verschmelzungsschicht nimmt die gesamte Umfangsfläche des Druckentlastungskörpers. Sie dient zum Porenverschluss und zusätzlich zur mechanischen Fixierung der miteinander durch Sinterung verbundenen Drahtgewebelagen des Druckentlastungskörpers. Prinzipiell ist dieses Konzept jedoch auch bei Druckentlastungskörpern anwendbar, die aus anderen porösen Materialien bestehen, beispielsweise aus miteinander versinterten Körpern oder Kugeln. Die Aufschmelzung der Umfangsfläche und Bedeckung mit Zuschlagstoff kann in einem oder mehreren Umläufen eines Schweißkopfs um den Druckentlastungskörper erfolgen, wobei nacheinander die Verschmelzung des Randes des Druckentlastungskörpers und eine Kehlnaht zur Verbindung des Druckentlastungskörpers und des Gehäuses (oder umgekehrt) erzeugt werden.

Der Druckentlastungskörper liegt auf dem die Druckentlastungsöffnung umgebenden Rand des Gehäuseteils (innen und/oder außen) auf, und ist dort mit diesem mit einer sich entlang des gesamten Umfangs des Druckentlastungskörpers unterbrechungsfrei erstreckenden Schweißnaht verschweißt. Das Gehäuseteil kann die Gehäusewand selbst oder ein gesonderter Träger sein, der mit dem Druckentlastungskörper verschweißt und mit der Gehäusewand verbunden ist. Das Gehäuseteil kann seinerseits mit der Gehäusewand verschweißt, verklebt, verschraubt oder in die Gehäusewand eingeformt, z.B. eingegossen sein

Unabhängig davon, ob der Druckentlastungskörper direkt mit der Gehäusewand oder mit einem als Träger ausgebildeten Gehäuseteil verbunden ist, kann der Druckentlastungskörper innerhalb des Gehäuses oder alternativ außerhalb des Gehäuses angeordnet sein. Es ist auch möglich, sowohl an der Innenseite wie auch an der Außenseite des Gehäuses oder Gehäuseteils jeweils einen Druckentlastungskörper anzuordnen.

Zusätzlich zur Schweißverbindung können zwischen der betreffenden Flachseite des Druckentlastungskörpers und dem die Druckentlastungsöffnung umgebenden Rand des Gehäuseteils Abdichtungsmaterialien, wie Klebstoff, Elastomer, Kunststoff oder dergleichen, oder sonstige Dichtungen, z.B. aus Metallgestrick oder Metallgewebe angeordnet sein.

Weiter ist es möglich, in dem Druckentlastungskörper einen oder mehrere Durchbrüche vorzugsehen, die in der die Druckentlastungsöffnung umgebenden Randzone positioniert sind und die bei der Befestigung des Druckentlastungskörpers an dem Gehäuseteil mit Schweißwerkstoff gefüllt werden. Diese Art der Befestigung wird auch Lochschweißung oder Schlitzschweißung genannt. Es kann auf eine außen ringsum entlang der Umfangsfläche verlaufende Schweißnaht verzichtet werden oder eine solche Schweißnaht zusätzlich angebracht werden. Außerdem ist die Umfangfläche mit einer Anschmelzung versehen. Optional kann zwischen dem Druckentlastungskörper und dem Gehäuseteil plastisches Dichtungsmaterial angeordnet sein.

Bei dem Gehäuse jeder der hier beschriebenen Bauarten kann die Druckentlastungsöffnung, unabhängig davon, ob der Druckentlastungskörper an der Gehäuseaußenseite oder in dem Gehäuseinnenraum an der Wandinnenseite angeordnet ist, durch Wandstege in mehrere Teilöffnungen unterteilt ausgebildet sein. Diese Maßnahme trägt zur Verbesserung der Verteilung des ausströmenden Gases über die Fläche des Druckentlastungskörpers bei. Der Wärmeeintrag in den Druckentlastungskörper wird auf einen größeren Teil seiner Fläche verteilt, wodurch wiederum die durch Gaskühlung erreichbare Druckreduktion steigt.

Anstelle der Wandstege oder zusätzlich zu diesen können zur Unterteilung der Gasströmung in oder an dem Druckentlastungskörper auch streifenförmige Presszonen vorgesehen sein, die sich z.B. von einer Stelle an dem Rand des Druckentlastungskörpers ausgehend bis zu einer anderen, am Rand gegenüberliegenden Stelle erstrecken. Die Presszonen sind plastisch deformierte Bereiche, in denen die Dicke des Druckentlastungskörpers reduziert ist. Es können mehrere sich kreuzende Presszonen vorgesehen sein. In den Presszonen ist das Porenvolumen reduziert oder beseitigt, so dass die Durchströmbarkeit dieser Zonen gegenüber den nichtkomprimierten Bereichen so weit reduziert ist, dass die die Druckentlastungsströmung auf die nichtkomprimierten Bereiche konzentriert.

Bei jedem der hier beschriebenen Gehäuse kann der Druckentlastungskörper angrenzend an die Umfangsfläche, die vorzugsweise als glatte Schnittfläche ausgebildet ist, ringsum mit einer plastisch deformierten und dadurch komprimierten Presszone versehen ist, in der das Porenvolumen reduziert oder beseitigt ist. Insbesondere kann dadurch das Volumen der zu erzeugenden Schweißnaht reduziert und auch die Schweißbarkeit des Druckentlastungskörpers verbessert werden. Vorzugsweise erstreckt sich die Presszone um den gesamten Umfang des Druckentlastungskörpers. Außerdem ist die Breite des streifenförmigen komprimierten Bereichs vorzugsweise wenigstens so groß wie die Dicke des Druckentlastungskörpers.

Weitere Einzelheiten vorteilhafter Ausführungsformen er Erfindung sind Gegenstand der Zeichnung, der Beschreibung oder von Ansprüchen, Es zeigen:
Figur 1 ein erfindungsgemäßes Gehäuse, in schematisierter Perspektivdarstellung,
Figur 2 das Gehäuse nach Figur 1, in einer weiter schematisierten Explosionsdarstellung,
Figur 3 das Gehäuse nach Figur 1, in einer ausschnittsweisen Schnittdarstellung der Verbindungsstelle zwischen dem Druckentlastungskörper und dem Gehäuseteil,
Figur 4 eine alternative Ausführungsform der Befestigung des Druckentlastungskörpers an dem Gehäuseteil,
Figur 5 eine nicht zur Erfindung gehörige Bauform, die lediglich der Veranschaulichung dient,
Figuren 6 bis 7 weitere alternative Ausführungsformen der Befestigung des Druckentlastungskörpers an dem Gehäuseteil, jeweils in ausschnittsweiser Längsschnittdarstellung,
Figur 8 ein Gehäuse mit Druckentlastungskörper, der durch punktuelle Schweißungen gehalten ist, in schematisierter perspektivischer Darstellung, und
Figur 9 das Gehäuse nach Figur 8, in Explosionsdarstellung,
Figur 10 das Gehäuse ähnlich Figur 1 mit randseitig komprimiertem Druckentlastungskörper, in einer ausschnittsweisen Schnittdarstellung der Verbindungsstelle zwischen dem Druckentlastungskörper und dem Gehäuseteil,
Figur 11 das Gehäuse ähnlich Figur 1 mit innenliegendem Druckentlastungskörper und Strömungsunterteilungsgitter.

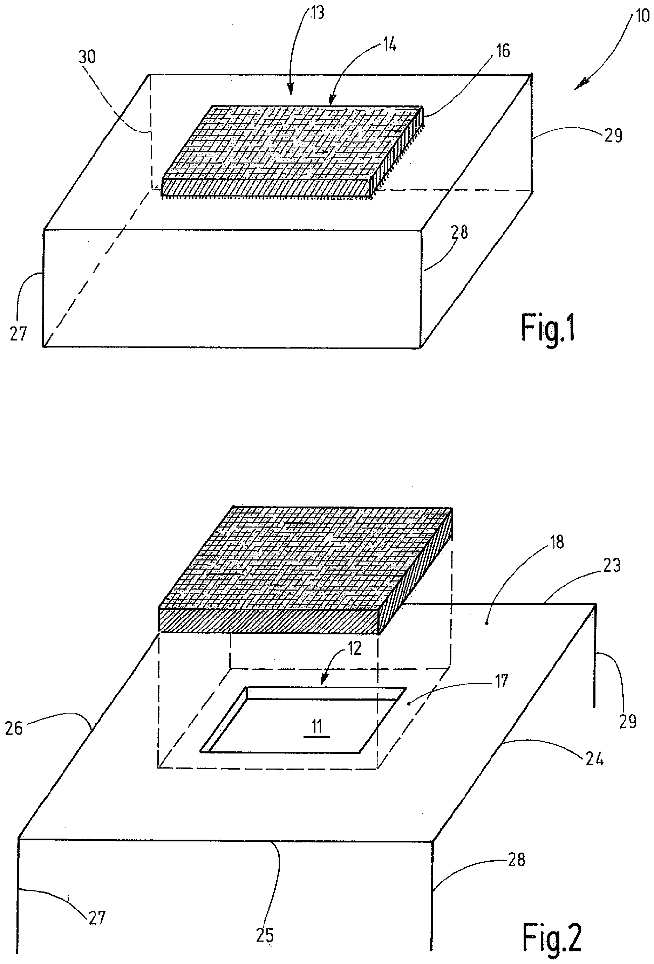

In Figur 1 ist ein Gehäuse 10 veranschaulicht, das als explosionsgeschütztes Gehäuse nach der Bauart "druckfeste Kapselung" (ex-d) ausgebildet ist. Es umschließt einen in Figur 2 angedeuteten Innenraum 11, in dem nicht weiter veranschaulichte elektrische und/oder elektronische Bauteile oder Komponenten angeordnet sein können, die Zündquellen für ein außerhalb des Gehäuses vorhandenes explosionsfähiges Gasgemisch darstellen können.

Das Gehäuse 10 weist eine z.B. aus Blech, insbesondere Stahlblech oder auch aus einem Gussmaterial, z.B. Aluminiumguss, bestehende Wandung auf, in der mindestens eine Druckausgleichsöffnung 12 ausgebildet ist, in oder an der ein Druckentlastungskörper 13 angeordnet ist. Dieser ist vorzugsweise ein plattenförmiger, ebener Sinterkörper mit einer ersten nach außen weisenden Flachseite 14 und einer zweiten, dem Innenraum 11 zugewandten Flachseite 15. Beide Flachseiten 14, 15 nehmen jeweils die gesamte Fläche der Druckausgleichsöffnung 12 ein und weisen auf ganzer Fläche Öffnungen von flammendurchschlagsicheren Kanälen auf, die sich durch den Druckentlastungskörper 13 erstrecken. Vorzugsweise wird der Druckentlastungskörper 13 durch miteinander verschweißte bzw. durch Sintern verbundene ebene Lagen aus Metallgewebe gebildet. Das Metallgewebe ist vorzugsweise aus Edelstahldrähten gefertigt. Der Sinterkörper weist eine ringsumlaufende Umfangsfläche 16 auf, die die beiden Flachseiten 14, 15 miteinander verbindet. Die Umfangsfläche 16 kann als abschnittsweise ebene, rechtwinklig zu den Flachseiten 14, 15 orientierte Fläche ausgebildet sein. Alternativ kann die Umfangsfläche 16 schräg zu den Flachseiten 14, 15 orientiert sein. Der Druckentlastungskörper kann bei dieser und allen anderen Ausführungsformen rechteckig, quadratisch, anderweitig polygonal begrenzt oder rund, z.B. als Kreisscheibe ausgebildet sein.

Der Druckentlastungskörper 13 weist vorzugsweise die gleiche Form auf wie die Druckausgleichsöffnung 12. Erfindungsgemäß ist der Druckentlastungskörper 13 größer als die Druckausgleichsöffnung 12 (siehe dazu insbesondere Figur 2). Deswegen ist die Druckausgleichsöffnung 12 von einem Randbereich 17 umgeben, auf dem der Druckentlastungskörper 13 in montiertem Zustand aufliegt. Der Randbereich 17 ist eine flache vorzugsweise ebene Zone eines Gehäuseteils 18, das durch ein Trägerteil oder von der Gehäusewand selbst gebildet sein kann. Das Gehäuseteil 18 ist aus einem schweißfähigen Werkstoff, insbesondere Stahl, vorzugsweise Stahlblech ausgebildet. In den Figuren 1, 2, 3, 8 und 9 ist der Druckentlastungskörper 13 an dem Gehäuse 10 außen angebracht dargestellt. Er kann aber gleichermaßen an der Druckausgleichsöffnung innen angebracht sein. Die nachfolgende Beschreibung gilt dann entsprechend.

Der Druckentlastungskörper 13 ist bei dem in den Figuren 1 und 2 veranschaulichten Ausführungsbeispiel des erfindungsgemäßen Gehäuses 10 an der Außenseite desselben angebracht. Die Flachseite 15 liegt auf dem Randbereich 17 des Gehäuseteils 18 (d.h. der Gehäusewand oder eines sonstigen flachen Trägerelements) auf und ist stoffschlüssig mit diesem verbunden. Dazu kann eine Schweißnaht 19 vorgesehen sein, die beispielsweise als Kehlnaht zwischen der Umfangsfläche 16 und der Außenseite der Gehäuseteil 18 ausgebildet ist. Die Schweißnaht 19 kann an dem Druckentlastungskörper 13 und an dem Gehäuseteil 18 gleiche oder unterschiedliche Einbrandtiefen aufweisen. Vorzugsweise wird die Scheißnaht 19 unter Zuhilfenahme eines Schweißzusatzwerkstoffs, typischerweise Stahlpulver oder auch Stahldraht erzeugt. Es können aber auch zusatzstofflose Schweißverfahren wie zum Beispiel Laserschweißen oder Schweißverfahren mit Zusatzwerkstoff, wie z.B. Laser-Pulver-Auftragschweißverfahren mit oder ohne Schutzgas angewandt werden.

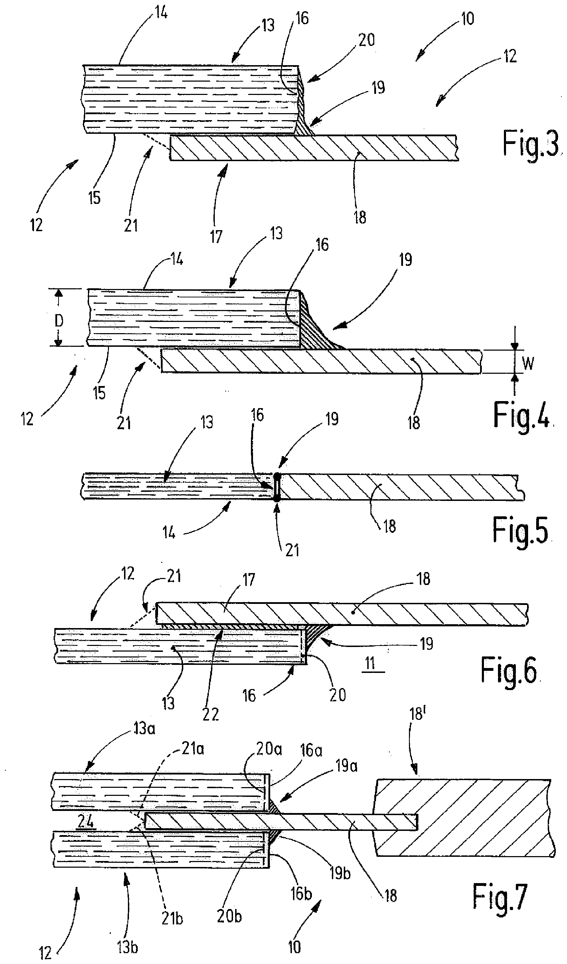

Bei dem in Figur 3 veranschaulichten und allen anderen Ausführungsbeispielen ist die Umfangsfläche 16 ganzflächig mit einer Verschmelzungsschicht 20 zu versehen, um die dort vorhandenen Poren des Druckentlastungskörpers 13 zu schließen. Die Verschmelzungsschicht 20 kann durch oberflächliches Anschmelzen der Umfangsfläche 16 durch geeignete Energieeinwirkung zum Beispiel mittels Lichtbogens, Laserstrahl, Plasmastrahl oder dergleichen mit oder ohne Zuhilfenahme eines Zusatzwerkstoffs erzeugt werden. Dabei wird durch lokale Energieeinwirkung ein oberflächliches Schmelzbad erzeugt und dieses dann durch Relativbewegung zwischen dem Strahl und dem Druckentlastungskörper 13 in einem oder mehreren Umläufen entlang der Umfangsfläche bewegt, um diese ganz oder teilweise mit der Verschmelzungsschicht zu versehen. Dabei können auch randnahe Bereiche der Flachseiten 14, 15 des Druckentlastungskörpers einbezogen werden.

Bei dem Ausführungsbeispiel nach Figur 3 lässt die Verschmelzungsschicht 20 einen kleinen Abschnitt der Umfangsfläche 16 frei. Es wird jedoch bevorzugt, die Verschmelzungsschicht 20 auf der gesamten Umfangsfläche 16 auszubilden und gegebenenfalls außerdem auf kleinere randnahe Teile der Flachseiten 14, 15 erstrecken. Die Schweißnaht 19 kann zwischen dem Druckentlastungskörper 13 und dem Gehäuseteil 18 ausgebildet werden, nachdem die Verschmelzungsschicht 20 ausgebildet worden ist. Es ist jedoch auch möglich, die Verschmelzungsschicht 20 und die Schweißnaht 19 gleichzeitig beispielsweise durch einen entsprechend bewegten Laserstrahl auszubilden.

Der Druckentlastungskörper 13 liegt gemäß Figur 3 ohne weitere Verbindung zu dem Gehäuseteil 18 auf dem Randbereich 17 auf. Es ist jedoch optional möglich, zur besseren Verbindung zwischen dem Druckentlastungskörper 13 und dem Gehäuseteil 18 eine weitere Schweißnaht 21 an der Druckentlastungsöffnung 12, d.h. deren Rand vorzusehen. Diese Schweißnaht 21 kann als Kehlnaht zwischen der Flachseite 15 und der Berandung der Druckentlastungsöffnung mit oder ohne Zusatzwerkstoff durch ein geeignetes Schweißverfahren ausgebildet sein. Weiter alternativ kann die Schweißnaht 21 die Schweißnaht 29 ersetzen. Wenigstens eine der beiden Schweißnähte 19, 21 ist ringförmig geschlossen ausgebildet.

Bei den insoweit beschriebenen und auch allen nachfolgend beschriebenen Ausführungsformen können als Schweißverfahren MIG-Schweißen, MAG-Schweißen, WIG-Schweißen, Lichtbogen-Handschweißen, Laserschweißen ohne Zusatzwerkstoff, Laserschweißen mit Zusatzwerkstoff, Unterpulverschweißen, Elektronenstrahlschweißen, Plasmaschweißen oder andere geeignete Schweißverfahren angewendet werden. Als Schweißverfahren werden alle stoffschlüssigen Verbindungsverfahren angesehen, bei denen eine Schweißnaht ausgebildet wird, die sowohl an dem Gehäuseteil 18 als auch an dem Druckentlastungskörper 13 einen Einbrand, d.h. einen Schmelzbereich aufweist.

Eine abgewandelte Ausführungsform des erfindungsgemäßen Gehäuses 10 veranschaulicht Figur 4. Die vorstehende Beschreibung gilt unter Zugrundelegung der bereits eingeführten Bezugszeichen entsprechend auch für diese Ausführungsform. Jedoch ist im Unterschied zu dem vorstehend beschriebenen Ausführungsbeispiel die Kehlnaht 19 so ausgebildet, dass sie zumindest einen großen Teil, vorzugsweise aber die gesamte Höhe der Umfangsfläche 16 einnimmt. Die Kehlnaht 19 bewirkt somit sowohl die Randabdichtung des Druckentlastungskörpers 13 wie auch dessen Befestigung. Zusätzlich oder alternativ zu der Kehlnaht 10 kann wiederum die an der Flachseite 15 ansetzende Schweißnaht 21 vorgesehen sein. Wenigstens eine der beiden Schweißnähte 19, 21 ist ringförmig geschlossen ausgebildet.

Bei dem vorstehend beschriebenen und allen nachfolgend beschriebenen Ausführungsformen der Erfindung kann, die zwischen den Flachseiten 14, 15 zu messende Dicke D des Druckentlastungskörpers von der Dicke W der Gehäusewand abweichen. Insbesondere kann die Dicke D des Druckentlastungskörpers 13 größer sein als die Dicke W des Gehäuseteils 18. Die Biegesteifigkeit des Druckentlastungskörpers 13 kann sich von der Biegesteifigkeit des Gehäuseteils 18 und/oder der Gehäusewand unterscheiden. Insbesondere ist es möglich, dass die Biegesteifigkeit des Druckentlastungskörpers 13 größer ist als diejenige des Gehäuseteils 18 und/oder der Gehäusewand. In diesen Fällen kann die Schweißnaht 19 oder die Schweißnaht 21 bei Kraftimpulsbelastung infolge einer im Gehäuse stattfindenden Explosion Mikrorelativbewegungen zwischen dem Druckentlastungskörper 13 und der Gehäusewand zulassen. Die Schweißnaht 19 oder 21 kann in diesem Fall nach Art eines Scharniers wirken, das zumindest geringe Winkel-Relativbewegungen zulässt.

Während die insoweit beschriebenen Ausführungsformen der Erfindung davon ausgehen, dass der Druckentlastungskörper 13 an die Außenseite des Gehäuses 10 angesetzt ist, wird hier nochmals darauf hingewiesen, dass der Druckentlastungskörper 13 auch innerhalb des Innenraums 11, d.h. von außen gesehen hinter der Druckentlastungsöffnung 12 angeordnet sein kann. Dies hat den Vorteil, dass der Druckentlastungskörper 13 im Falle einer Explosion zu der Gehäusewand hin gedrückt und somit durch diese Formschlüssig gehalten wird.

Es wird auf Figur 5 verwiesen. Dieser Aspekt ist nicht erfindungsgemäß und dient lediglich der Veranschaulichung; der Druckentlastungskörper 13 weist dort beispielhaft eine mit der Dicke W des Gehäuseteils 18 übereinstimmende Dicke D auf. Er ist wiederum durch ein oder zwei Schweißnähte 19, 21 mit dem Gehäuseteil 18 verbunden, von denen mindestens eine sich um den gesamten Umfang des Druckentlastungskörpers erstreckt. Die Schweißnähte 19, 21 können Stumpfnähte sein, die mit oder ohne Zusatzwerkstoff in einem der oben genannten Schweißverfahren erzeugt sind und sich wie dargestellt auf den oberen und unteren Rand der Druckentlastungsöffnung beschränken. Es ist jedoch auch möglich, zwischen dem Druckentlastungskörper 13 und dem Umfang der Druckentlastungsöffnung 12 eine Stumpfnaht vorzusehen, die die Umfangsfläche 16 vollflächig einnimmt. Dies ist beispielsweise durch Laserschweißen möglich. Außerdem kann der Druckentlastungskörper 13 auch eine von der Dicke des Gehäuseteils 18 abweichenden größeren oder kleineren Dicke aufweisen. Er kann zentrisch angeordnet sein, so dass seine mittig zwischen den beiden Flachseiten 14, 15 liegende Mittelebene mit der Mittelebene des Gehäuseteils 18 übereinstimmt. Alternativ kann er auch außermittig angeordnet sein, so dass seine Mittelebene in einem Abstand zu der Mittelebene des Gehäuseteils angeordnet ist.

Figur 6 veranschaulicht eine Ausführungsform mit Befestigung des Druckentlastungskörpers 13 in dem Innenraum 11, so dass der Druckentlastungskörper 13 den Randbereich 17 der Druckentlastungsöffnung 12 hintergreift. Die Umfangsfläche 16 ist mit der Verschmelzungsschicht 20 versehen. Zur gasdichten und mechanisch festen Verbindung zwischen dem Druckentlastungskörper 13 und dem Gehäuseteil 18 können die rings um die Umfangsfläche 16 führende Schweißnaht 19 und/oder die um den Rand der Druckentlastungsöffnung 12 herum führende Schweißnaht 21 vorgesehen sein. Wie bei allen Ausführungsbeispielen ist wenigstens eine der Schweißnähte 19 und 21 unterbrechungsfrei ausgebildet, so dass sie einen geschlossenen Ring bildet (bzw. bilden).

An dem in Figur 6 veranschaulichten Ausführungsbeispiel ist auch verdeutlicht, dass zwischen dem Druckentlastungskörper 13 und dem Randbereich 17 des Gehäuseteils 18 eine Dichtung 22 angeordnet sein kann. Diese kann aus formloser Masse wie Klebstoff, Elastomer oder dergleichen oder auch aus einem Körper definierter Form, wie zum Beispiel einer Gummizwischenlage oder einer Zwischenlage aus geeigneten Dichtungsmaterial, bestehen. Eine solche Dichtung 22 kann bei jeder der beschriebenen Ausführungsformen mit Ausnahme der Ausführungsform nach Figur 5 vorgesehen werden.

Bei jeder der vorstehend beschriebenen Ausführungsformen kann der Druckentlastungskörper 13 direkt mit der Gehäusewand oder lediglich mit einem entsprechenden vorzugsweise aus Blech bestehenden Gehäuseteil 18 verschweißt sein, das seinerseits mit der Gehäusewand verbunden ist. Figur 7 veranschaulicht dies am Beispiel einer im Gussverfahren, beispielsweise Aluminiumguss, hergestellten Gehäusewand 18', in die ein ebener ringförmiger Träger eingegossen ist, der den Gehäuseteil 18 bildet. Dieser Träger umschließt ringförmig die Druckentlastungsöffnung 12 und kann mit dem Druckentlastungskörper 13 nach jeder der oben beschriebenen Arten verbunden sein. Die gegossene Wand kann sich bis an den Druckentlastungskörper 13a und/oder 13b heran erstrecken oder, wie dargestellt, einen Abstand zu diesem einhalten.

Grundsätzlich ist es jedoch auch möglich, an einer Druckentlastungsöffnung 12 sowohl an der Außenseite wie auch an der Innenseite einen Druckentlastungskörper 13 anzubringen, wobei dazu jede der in den Figuren 3, 4 und 6 veranschaulichten Strukturen und Verfahren angewendet und beliebig miteinander kombiniert werden können. Dies ist unabhängig davon, ob das Gehäuseteil 18 ein in die Gehäusewand 18' eingegossener Träger ist, wie es in Figur 7 veranschaulicht ist, oder ob das Gehäuseteil 18 selbst die Gehäusewand bildet.

Wenn, wie es Figur 7 veranschaulicht ist, zu beiden Seiten des Gehäuseteils 18 jeweils ein Druckentlastungskörper 13a, 13b angeordnet ist, ist zwischen beiden Druckentlastungskörpern 13a, 13b ein Diffusionsraum 24 festgelegt, der zu einer Vergleichmäßigung der Gasströmung durch die beiden Druckentlastungskörper 13a, 13b führt. Dies kann zu einer besonders wirksamen Minderung von Druckspitzen in dem Gehäuse 10 führen.

Wenn die beiden Druckentlastungskörper 13a, 13b gemeinsam an einer Druckentlastungsöffnung 12 vorgesehen sind, können beide durch an den Umfangsflächen 16a, 16b vorgesehene Kehlnähte 19a, 19b an dem Gehäuseteil 18 gehalten sein. Die Kehlnähte 19a, 189b können die Umfangsflächen 16a, 16b vollständig oder teilweise einnehmen. An den Umfangsflächen 16a, 16b wenigstens eines der Druckentlastungskörper 13a, 13b können Verschmelzungsschichten 20a, 20b vorgesehen sein. Es sind auch asymmetrische Lösungen möglich, bei denen nur einer der Druckentlastungskörper 13a, 13b mit einer äußeren Kehlnaht 19a oder 19b unter jeweils andere mit einer inneren Kehlnaht 21a oder 21b fixiert ist. Auch bei einer solchen Lösung kann wiederum wenigstens einer der Druckentlastungskörper 13a, 13b mit einer Verschmelzungsschicht 20a, 20b an seinem Umfang versehen sein. Auch können zusätzlich Abdichtungsmaßnahmen zum Beispiel in Gestalt von Dichtungen nach Art der Dichtung 22 in Figur 6 vorgesehen sein.

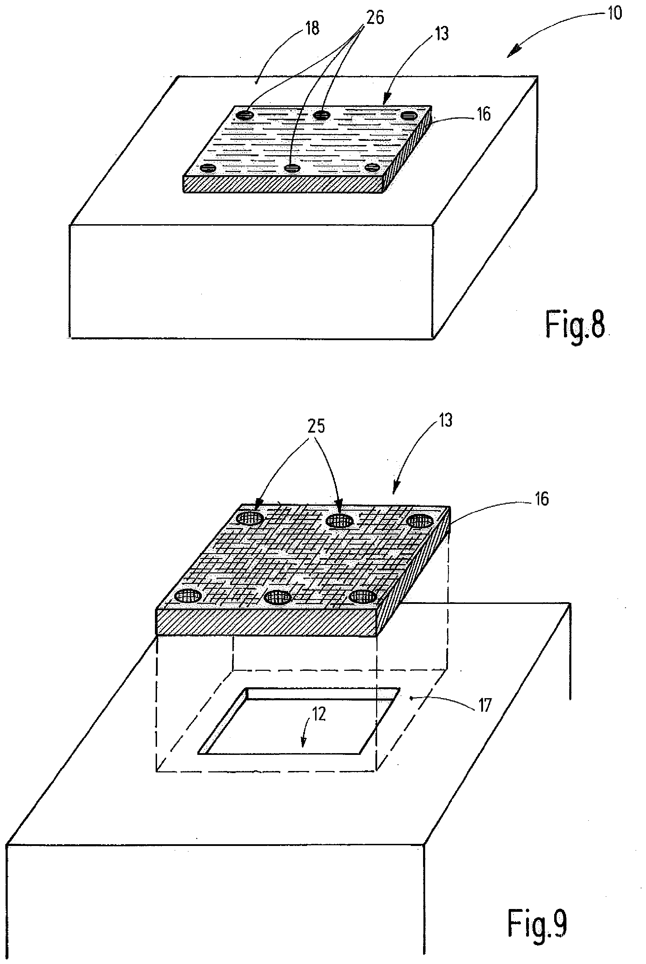

Während bei allen vorstehenden Ausführungsformen die Schweißnähte 19 und 21 entweder rings um die Außenumfangsfläche 15 des Druckentlastungskörpers 13 oder im Fall der Schweißnaht 21 entlang des Randes der Druckentlastungsöffnung 12 führen sind alternative Ausführungsformen möglich, wie es die Figuren 8 und 9 veranschaulichen. Der dort dargestellte Druckentlastungskörper 13 weist mehrere Öffnungen 25 auf, die auf den Randbereich 17 führen, wenn der Druckentlastungskörper 13 auf der Druckentlastungsöffnung 12 platziert ist. Die Ausnehmungen können im Schweißverfahren mit Schweißzusatzwerkstoff gefüllt sein, wobei die so gebildete Verschweißung den Randbereich 17 mit dem Druckentlastungskörper 13 verbindet. Die Umfangsflächen 16 des Druckentlastungskörpers 13 ist nach einem der vorstehend genannten Verfahren mit einer Verschmelzungsschicht 20 versehen. Der nach diesem Konzept mit dem Gehäuseteil 18 verbundene Druckentlastungskörper 13 kann sowohl an der Außenseite des Gehäuses 10, wie in Figur 8 dargestellt ist, als auch im Innenraum des Gehäuses 10 angeordnet und von innen her mit dem Randbereich 17 des Gehäuseteils 18 verbunden sein. Außerdem kann das Gehäuseteil 18 die Gehäusewand selbst oder ein mit diese verbundener Träger sein. Zur zusätzlichen Abdichtung zwischen dem Gehäuseteil 18 und dem Druckentlastungskörper 13 kann die Außenumfangsfläche 16 mit dem Gehäuseteil 18 über eine Kehlnaht verbunden sein. Zusätzlich oder alternativ kann eine den Rand der Druckentlastungsöffnung 12 mit der zugewandten Flachsseite 15 verbindende rings um die Druckentlastungsöffnung 12 führende Schweißnaht vorgesehen sein.

Bei allen Ausführungsformen kann die Anbringung des Druckentlastungskörpers 13 an die Gehäusewand als flaches Blech vor der Ausformung des Gehäuseteils 18 erfolgen. Der Druckentlastungskörper 13 wird dazu an einem flachen, mit der Druckausgleichsöffnung 12 versehenen Blech befestigt, wonach das Blech an den vorgesehenen Biegelinien 23 - 26 (siehe Figur 2) abgewinkelt und die Gehäusekanten 27 - 30 vorzugsweise mit dem gleichen Schweißverfahren verschweißt werden, das auch zur Befestigung des Druckentlastungskörpers 13 an dem Gehäuse 18 dient.

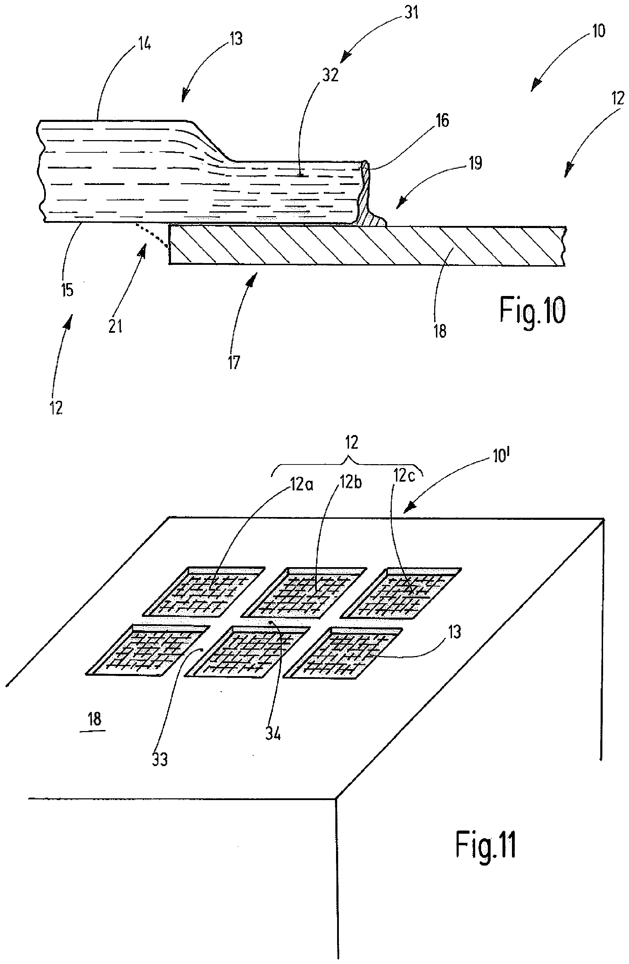

Bei allen vor- oder nachstehend beschriebenen Ausführungsformen kann der Druckentlastungskörper 13 eine Modifikation aufweisen, die am Beispiel der Ausführungsform nach Figur 10 veranschaulicht ist. Der Druckentlastungskörper 13 kann an seinem Rand 31, der sich vorzugsweise direkt an die Außenumfangsfläche 16 anschließt, eine Kompressionszone 32 aufweisen, in der der Druckentlastungskörper 13 zusammengedrückt ist, so dass das vorhandene Porenvolumen deutlich reduziert oder beseitigt ist. Die plastische Deformation zur Erzeugung der Kompressionszone 32 kann zum Beispiel in kaltem Zustand des aus gesinterten Drahtgewebe bestehenden Druckentlastungskörpers 13 in einem Kaltverformprozess stattfinden. Es ist auch möglich, die Kompression unter Zuhilfenahme einer zuvorigen oder während der Kompression stattfindenden Erwärmung des Druckentlastungskörpers 13 wenigstens in dem zu komprimierenden Bereich vorzunehmen. Die Kompression kann, wie in Figur 10 dargestellt, einseitig stattfinden, so dass die Flachseite 15 vollständig eben und die Flachseite 14 mit einer Stufe versehen wird. Es ist auch möglich, die sich durch die Dickenreduktion des Druckentlastungskörpers 13 an seinem Rand 31 ergebende Abstufung auf beide Flachseiten 14, 15 zu verteilen.

Der komprimierte Rand 31 kann eine Breite aufweisen, die geringer ist als die Breite des Randbereichs 17, wobei der Druckentlastungskörper 13, wie in Figur 1 angedeutet, an dem Gehäuse angeschweißt sein kann. Er kann jedoch auch gemäß Figur 5 in die Druckentlastungsöffnung 12 eingesetzt oder entsprechend Figur 6 an der Innenseite des Gehäuseteils 18 angebracht sein. Es ist auch möglich, einen oder zwei solcher Druckentlastungskörper wie die Druckentlastungskörper 13a, 13b nach Figur 7 ein- oder beidseitig an einem Gehäuseteil 18 anzubringen, das seinerseits an einer Gehäusewand befestigt ist, beispielsweise entsprechend Figur 7 durch Eingießen in eine Gehäusewand 18'.

In Figur 11 ist eine weitere Abwandlung des erfindungsgemäßen Gehäuses als Gehäuse 10' veranschaulicht, dessen Besonderheit darin besteht, dass die Druckentlastungsöffnung 12 in Teilöffnungen 12a, 12b, 12c, usw., unterteilt ist. Die Unterteilung der Druckentlastungsöffnung 12 in Teilöffnungen 12a, b, c, usw., erfolgt durch Wandstege 33, 34. Vorzugsweise sind diese einstückiger Bestandteil des Gehäuseteils 18, wobei sie vorzugsweise ein regelmäßiges Gitter bilden. Der Druckentlastungskörper 13 überdeckt vorzugsweise alle Teilöffnungen 12a, 12b, 12c usw. Alternativ können aber auch jeweils lediglich zwei oder mehrere Druckentlastungskörper vorgesehen sein, die jeweils ein oder mehrere der Teilöffnungen abdecken und entsprechend mit den Wandstegen 33, 34 verschweißt sind. Bei der bevorzugten Ausführungsform ist jedoch lediglich ein einziger Druckentlastungskörper 13 vorgesehen, der alle Teilöffnungen 12a, 12b, 12c, usw., überbrückt und mit der Gehäusewand des Gehäuseteils 18 lediglich an seinem alle Teilöffnungen 12a, b, c, usw. umgebende Umfang verschweißt ist. Mit dem durch die Wandstege 33, 34 erzeugten Gitter wird eine Druckentlastungsströmung in Teilströmungen aufgeteilt, womit der Wärmeeintrag in den Druckentlastungskörper 13 auf eine größere Fläche verteilt und somit die Wirksamkeit des Druckentlastungskörpers 13 zum Druckabbau vergrößert wird.

Ein durch Wandstege 33, 34 gebildetes Gitter kann auch an dem Gehäuseteil 18 nach Figur 7 ausgebildet sein, wobei es dann zwischen den beiden Druckentlastungskörpern 13, 13b liegt. Ebenso kann es bei den Ausführungsformen nach Figur 1 bis 4 sowie 8 und 9 zur Anwendung kommen.

Es wird darauf hingewiesen, dass der Druckentlastungskörper 13 bei allen vorstehend beschriebenen Ausführungsformen anstelle der Schweißverbindung auch anderweitig mit dem Gehäuseteil 18 verbunden sein kann, beispielsweise durch Kleben oder auch Löten insbesondere Hartlöten (Ofenlöten oder dergleichen). Weiter ist es möglich, die stoffschlüssige Verbindung durch formschlüssige Verbindungen zu unterstützen, beispielsweise durch Schraubverbindungen, Klemmverbindungen oder dergleichen. Beispielsweise können am Rand des Druckentlastungskörpers 13, insbesondere, sofern vorhanden, in der Kompressionszone 32 Schrauben vorgesehen sein, die zusätzlich zu einer stoffschlüssigen Verbindung, wie beispielsweise einer Klebeverbindung, eine formschlüssige Sicherung des Druckentlastungskörpers 13 an dem Gehäuseteil 18 bewirken.

Ein aus Drahtgewebe gesinterter Druckentlastungskörper 13 ist an einem explosionsgeschützten Gehäuse durch Schweißung gehalten. Die entsprechende Schweißnaht 19 und/oder 21 weist einen Einbrand sowohl seitens des Druckentlastungskörpers 13 wie auch seitens des Gehäuseteils 18 auf und verbindet beide mechanisch fest und gasdicht.

**Bezugszeichen:**

| | |
|---|---|
| 10, 10' | Gehäuse |
| 11 | Innenraum |
| 12 | Druckentlastungsöffnung |
| 13, 13a, 13b | Druckentlastungskörper |
| 14 | äußere Flachseite des Druckentlastungskörpers 13 |
| 15 | innere Flachseite des Druckentlastungskörpers 13 |
| 16 | Außenumfangsfläche des Druckentlastungskörpers 13 |
| 17 | Randbereich |
| 18 | Gehäuseteil |
| 18' | Gehäusewand (z.B. Aluminiumguss) |
| 19 | Schweißnaht |
| 20 | Verschmelzungsschicht |
| 21 | Schweißnaht |
| 22 | Dichtung |
| 23 - 26 | Biegelinien |
| 27 - 30 | Gehäusekanten |
| 31 | Rand des Druckentlastungskörpers 13 |
| 32 | Kompressionszone |
| 33, 34 | Wandstege |
| | |

## Patentansprüche

1. Explosionsgeschütztes Gehäuse (10) nach der Bauart "Druckfeste Kapselung" (ex-d),
das einen Innenraum (11) umgrenzt, in dem elektrische Komponenten unterbringbar sind, die Zündquellen bilden können, und das einen Gehäuseteil (18) aus schweißfähigem Werkstoff aufweist, an dem eine Druckausgleichsöffnung (12) ausgebildet ist,
mit wenigstens einem Druckentlastungskörper (13), der zwei voneinander weg weisende Flachseiten (14, 15) und eine die Flachseiten (14, 15) verbindende Umfangsfläche (16) aufweist und an der Druckausgleichsöffnung (12) angeordnet ist,
wobei
der Druckentlastungskörper (13) mit dem Gehäuseteil (18) verschweißt oder anderweitig stoffschlüssig verbunden ist,
wobei
der Druckentlastungskörper (13) größer als die Druckentlastungsöffnung (12) ist, wodurch die Druckausgleichsöffnung (12) von einem Randbereich (17) umgeben ist, auf dem der Druckentlastungskörper (13) in montiertem Zustand aufliegt,
wobei die Umfangsfläche (16) des Druckentlastungskörpers (13) als eine Verschmelzungsschicht (20) ausgebildet ist, die sich von einer der Flachseiten (14) bis zu der anderen Flachseite (15) und entlang der gesamten Umfangsfläche (16) des Druckentlastungskörpers (13) erstreckt und diese vollständig bedeckt,
wobei der Druckentlastungskörper (13) auf dem die Druckentlastungsöffnung (12) des Gehäuseteils (18) umgebenden Randbereich (17) aufliegend angeordnet ist und
wobei die Umfangsfläche (16) des Druckentlastungskörpers (13) frei liegend mit direkter Berührung der umgebenden Atmosphäre oder des Innenraums angeordnet ist.

2. Gehäuse nach Anspruch 1, **dadurch gekennzeichnet, dass** der Druckentlastungskörper (13) ein Drahtnetz-Sinterkörper ist, der aus mehreren miteinander durch Sinterung verbundenen Drahtgewebelagen besteht.

3. Gehäuse nach einem der vorstehenden Ansprüche, **dadurch gekennzeichnet, dass** der Druckentlastungskörper (13) angrenzend an die Umfangsfläche (16), die vorzugsweise als glatte Schnittfläche ausgebildet ist, ringsum mit einer Presszone versehen ist, in der das Porenvolumen reduziert oder beseitigt ist.

4. Gehäuse nach einem der vorstehenden Ansprüche, **dadurch gekennzeichnet, dass** die Verschmelzungsschicht (20) durch eine Schweißnaht (19) ausgebildet ist.

5. Gehäuse nach einem der vorstehenden Ansprüche, **dadurch gekennzeichnet, dass** die Flachseiten (14, 15) des Druckentlastungskörpers (13) eben ausgebildet sind.

6. Gehäuse nach einem der vorstehenden Ansprüche, **dadurch gekennzeichnet, dass** der Druckentlastungskörper (13) und die Druckentlastungsöffnung (12) jeweils einen rechteckigen Umriss aufweisen, wobei der Umriss des Druckentlastungskörpers (13) größer ist als der Umriss der Druckentlastungsöffnung (12).

7. Gehäuse nach einem der vorstehenden Ansprüche, **dadurch gekennzeichnet, dass** die Druckentlastungsöffnung (12) durch Wandstege (33, 34) in mehrere Teilöffnungen (12a, 12b) unterteilt ist.

8. Gehäuse nach einem der vorstehenden Ansprüche, **dadurch gekennzeichnet, dass** der Druckentlastungskörper (13) über eine Schweißnaht (19) mit dem Gehäuseteil (18) verbunden ist.

9. Gehäuse nach einem der vorstehenden Ansprüche, **dadurch gekennzeichnet, dass** der Druckentlastungskörper (13) einen oder mehrere Durchgänge aufweist, an denen der Druckentlastungskörper (13) mit dem Gehäuseteil (18) verschweißt ist.

10. Verfahren zur Herstellung eines explosionsgeschützten Gehäuses, mit folgenden Schritten:
Bereitstellung eines Gehäuses (10) das einen Innenraum (11) umgrenzt, in dem elektrische Komponenten unterbringbar sind, die Zündquellen bilden können, und das einen Gehäuseteil aus schweißfähigem Werkstoff (18) aufweist, an dem eine Druckausgleichsöffnung (12) ausgebildet ist,
Bereitstellung wenigstens eines Druckentlastungskörpers (13), der zwei voneinander weg weisende Flachseiten (14, 15) und eine die Flachseiten (14, 15) verbindende Umfangsfläche (16) aufweist
Anordnen des Druckentlastungskörpers (13), der größer ist als die Druckentlastungsöffnung (12), an der Druckausgleichsöffnung (12), indem der Druckentlastungskörper (13) auf einen die Druckausgleichsöffnung (12) umgebenden Randbereich (17) aufgelegt wird, Anschmelzen des Druckentlastungskörpers (13) an seiner Umfangsfläche (16) und Ausgebilden einer Verschmelzungsschicht (20), die sich von einer der Flachseiten (14) bis zu der anderen Flachseite (15) und entlang der gesamten Umfangsfläche (16) des Druckentlastungskörpers (13) erstreckt und diese vollständig bedeckt, um Poren zu schließen, und
Verschweißen des Druckentlastungskörpers (13) mit dem Gehäuseteil (18),
wobei der Druckentlastungskörper (13) auf dem die Druckentlastungsöffnung (12) des Gehäuseteils (18) umgebenden Randbereich (17) aufliegend angeordnet wird und
wobei die Umfangsfläche (16) des Druckentlastungskörpers (13) frei liegend mit direkter Berührung der umgebenden Atmosphäre oder des Innenraums angeordnet ist.

11. Verfahren nach Anspruch 10, **dadurch gekennzeichnet, dass** die zur Verbindung des Druckentlastungskörpers (13) dienende Schweißnaht (19) entlang der gesamten Umfangsfläche (16) und/oder in Durchbrüchen ununterbrochen ausgebildet wird.

## Claims

1. Explosion-proof housing (10) in the manner of a "pressure-resistant encapsulation" (ex-d) which delimits an interior (11) which may accommodate electrical components that may form ignition sources, and which has a housing part (18) of weldable material on which a pressure-compensation opening (12) is formed,
with at least one pressure-relief body (13) which has two flat sides (14, 15) pointing away from one another and a circumferential surface (16) connecting the flat sides (14, 15) and on which the pressure-compensation opening (12) is arranged,
wherein the pressure-relief body (13) is welded to the housing part (18) or otherwise connected thereto by substance bonding,
wherein the pressure-relief body (13) is larger than the pressure-relief opening (12), whereby the pressure-compensation opening (12) is surrounded by an edge opening (17) on which the pressure-relief body (13) lies in mounted state,
wherein the circumferential surface (16) of the pressure-relief body (13) is formed as a melt layer (20) which extends from one of the flat sides (14) to the other flat side (15) and along the entire circumferential face (16) of the pressure-relief body (13) and completely covers these,
wherein the pressure-relief body (13) is arranged lying on the edge region (17) surrounding the pressure-relief opening (12) of the housing part (18), and
wherein the circumferential face (16) of the pressure-relief body (13) is arranged exposed in direct contact with the surrounding atmosphere or interior.

2. Housing according to claim 1, **characterised in that** the pressure-relief body (13) is a wire-mesh sintered body which consists of several wire-weave layers connected together by sintering.

3. Housing according to any of the preceding claims, **characterised in that** adjacent to the circumferential face (16) which is preferably configured as a smooth interface, the pressure-relief body (13) is provided with a pressing zone all around in which the pore volume is reduced or eliminated.

4. Housing according to any of the preceding claims, **characterised in that** the melt layer (20) is formed by a weld seam (19).

5. Housing according to any of the preceding claims, **characterised in that** the flat sides (14, 15) of the pressure-relief body (13) are formed level.

6. Housing according to any of the preceding claims, **characterised in that** the pressure-relief body (13) and the pressure-relief opening (12) each have a rectangular contour, wherein the contour of the pressure-relief body (13) is larger than the contour of the pressure-relief opening (12).

7. Housing according to any of the preceding claims, **characterised in that** the pressure-relief opening (12) is divided into several part openings (12a, 12b) by wall webs (33, 34).

8. Housing according to any of the preceding claims, **characterised in that** the pressure-relief body (13) is connected to the housing part (18) via a weld seam (19).

9. Housing according to any of the preceding claims, **characterised in that** the pressure-relief body (13) has one or more passages at which the pressure-relief body (13) is welded to the housing part (18).

10. Method for producing an explosion-proof housing, with the following steps:
- provision of a housing (10) which delimits an interior (11) which may accommodate electrical components that may form ignition sources, and which has a housing part (18) of weldable material on which a pressure-compensation opening (12) is formed,
- provision of at least one pressure-relief body (13) which has two flat sides (14, 15) pointing away from one another and a circumferential surface (16) connecting the flat sides (14, 15),
- arrangement of the pressure-relief body (13), which is larger than the pressure-relief opening (12), on the pressure-compensation opening (12) in that the pressure-relief body (13) is laid on an edge region (17) surrounding the pressure-compensation opening (12),
- melting of the pressure-relief body (13) at its circumferential surface (16) and formation of a melt layer (20) which extends from one of the flat sides (14) to the other flat side (15) and along the entire circumferential face (16) of the pressure-relief body (13) and completely covers these so as to close pores, and
- welding of the pressure-relief body (13) to the housing part (18),
wherein the pressure-relief body (13) is arranged lying on the edge region (17) surrounding the pressure-relief opening (12) of the housing part (18), and wherein the circumferential face (16) of the pressure-relief body (13) is arranged exposed in direct contact with the surrounding atmosphere or interior.

11. Method according to claim 10, **characterised in that** the weld seam (19) serving to connect the pressure-relief body (13) is formed uninterruptedly along the entire circumferential surface (16) and/or in the openings.

## Revendications

1. Boîtier antidéflagrant (10) du type « enveloppe résistant à la pression » (ex-d),
qui délimite un espace interne (11) dans lequel peuvent être logés des composants électriques pouvant constituer des sources d'inflammation, et qui présente une partie de boîtier (18) en matériau soudable, sur lequel est réalisée une ouverture de compensation de pression (12),
comprenant au moins un corps de décharge de pression (13) qui présente deux faces plates (14, 15), orientées dans des directions opposées l'une par rapport à l'autre, et une surface périphérique (16) reliant les faces plates (14, 15), et qui est disposé sur l'ouverture de compensation de pression (12),
sachant que le corps de décharge de pression (13) est soudé à la partie de boîtier (18) ou y est relié d'une autre manière, par adhérence,
sachant que le corps de décharge de pression (13) est plus grand que l'ouverture de décharge de pression (12), ce qui a pour effet que l'ouverture de compensation de pression (12) est entourée d'une zone de bord (17) sur laquelle repose le corps de décharge de pression (13) à l'état monté,
sachant que la surface périphérique (16) du corps de décharge de pression (13) est réalisée sous forme de couche de fusion (20) qui s'étend de l'une (14) des faces plates (14) jusqu'à l'autre face plate (15) et le long de l'ensemble de la surface périphérique (16) du corps de décharge de pression (13) et recouvre entièrement celle-ci,
sachant que le corps de décharge de pression (13) est disposé de manière à reposer sur la zone de bord (17) entourant l'ouverture de décharge de pression (12) de la partie de boîtier (18), et
sachant que la surface périphérique (16) du corps de décharge de pression (13) est disposée en étant dégagée, en contact direct avec l'atmosphère environnante ou l'espace interne.

2. Boîtier selon la revendication 1, **caractérisé en ce que** le corps de décharge de pression (13) est un corps fritté à treillis métallique qui est constitué de plusieurs couches de toile métallique liées entre elles par frittage.

3. Boîtier selon l'une des revendications précédentes, **caractérisé en ce que**, à proximité de la surface périphérique (16) qui est de préférence réalisée sous forme de surface de coupe lisse, le corps de décharge de pression (13) est doté sur tout le pourtour d'une zone de pression dans laquelle le volume de pores est réduit ou supprimé.

4. Boîtier selon l'une des revendications précédentes, **caractérisé en ce que** la couche de fusion (20) est constituée d'un joint de soudure (19).

5. Boîtier selon l'une des revendications précédentes, **caractérisé en ce que** les faces plates (14, 15) du corps de décharge de pression (13) sont réalisées sous une forme plane.

6. Boîtier selon l'une des revendications précédentes, **caractérisé en ce que** le corps de décharge de pression (13) et l'ouverture de décharge de pression (12) présentent respectivement un contour rectangulaire, le contour du corps de décharge de pression (13) étant plus grand que le contour de l'ouverture de décharge de pression (12).

7. Boîtier selon l'une des revendications précédentes, **caractérisé en ce que** l'ouverture de décharge de pression (12) est divisée en plusieurs ouvertures élémentaires (12a, 12b) par des entretoises (33, 34).

8. Boîtier selon l'une des revendications précédentes, **caractérisé en ce que** le corps de décharge de pression (13) est lié par un joint de soudure (19) à la partie de boîtier (18).

9. Boîtier selon l'une des revendications précédentes, **caractérisé en ce que** le corps de décharge de pression (13) présente un ou plusieurs passages au niveau desquels le corps de décharge de pression (13) est lié à la partie de boîtier (18).

10. Procédé de fabrication d'un boîtier antidéflagrant, comprenant les étapes suivantes :
mise à disposition d'un boîtier (10) qui délimite un espace interne (11) dans lequel peuvent être logés des composants électriques pouvant constituer des sources d'inflammation, et qui présente une partie de boîtier en matériau apte au soudage (18), sur lequel est réalisée une ouverture de compensation de pression (12),
mise à disposition d'au moins un corps de décharge de pression (13) qui présente deux faces plates (14, 15), orientées dans des directions opposées l'une par rapport à l'autre, et une surface périphérique (16) qui relie les faces plates (14, 15),
mise en place du corps de décharge de pression (13), qui est plus grand que l'ouverture de décharge de pression (12), sur l'ouverture de compensation de pression (12), en posant le corps de décharge de pression (13) sur une zone de bord (17) entourant l'ouverture de compensation de pression (12),
mise en fusion du corps de décharge de pression (13) sur sa surface périphérique (16), et réalisation d'une couche de fusion (20) qui s'étend de l'une (14) des faces plates jusqu'à l'autre face plate (15) et le long de l'ensemble de la surface périphérique (16) du corps de décharge de pression (13) et recouvre entièrement celle-ci, en vue de fermer des pores, et
soudage du corps de décharge de pression (13) avec la partie de boîtier (18),
sachant que le corps de décharge de pression (13) est disposé de manière à reposer sur la zone de bord (17) entourant l'ouverture de décharge de pression (12) de la partie de boîtier (18), et
sachant que la surface périphérique (16) du corps de décharge de pression (13) est disposée en étant dégagée, en contact direct avec l'atmosphère environnante ou l'espace interne.

11. Procédé selon la revendication 10, **caractérisé en ce que** le joint de soudure (19) servant à la liaison du corps de décharge de pression (13) est réalisé le long de l'ensemble de la surface périphérique (16) et/ou de manière non interrompue dans des passages.
